# EUROPÄISCHE PATENTSCHRIFT

(11) **EP 2 704 262 B1**
(45) Veröffentlichungstag und Bekanntmachung des Hinweises auf die Patenterteilung: **02.05.2018**
(21) Anmeldenummer: 13003876.3
(22) Anmeldetag: 02.08.2013
(51) Int. Cl.: H05K 5/06, H01R 13/533, H01R 13/74, H01R 13/52

(54) **Hermetische Gehäuseanordnung**
Hermetic housing arrangement
Agencement de boîtier hermétique

(30) Priorität: 31.08.2012 DE 102012017357
(43) Veröffentlichungstag der Anmeldung: 05.03.2014
(73) Patentinhaber: Liebherr-Elektronik GmbH, 88131 Lindau (DE)
(72) Erfinder: Matuschek, Daniel, 88353 Kißlegg (DE); Grau, Hubert, 88142 Wasserburg (DE)
(74) Vertreter: Laufhütte, Dieter

(56) Entgegenhaltungen:
- DE-A1- 19 506 665
- DE-B3-102006 037 355
- GB-A- 2 135 533
- JP-A- 2000 277 203
- JP-A- 2007 073 269
- US-A1- 2005 153 586
- US-A1- 2005 269 120
- US-A1- 2008 045 072
- US-B1- 6 217 737

## Beschreibung

Die vorliegende Erfindung betrifft eine Gehäuseanordnung, insbesondere eine hermetische Gehäuseanordnung, mit wenigstens einem Gehäuse zur Anbindung wenigstens eines Steckverbinders, wobei die Gehäuseanordnung wenigstens eine Dichtung aufweist, gemäß Anspruch 1.

Hermetisch abgedichtete Gehäuse werden verwendet, um die sich darin befindenden Teile vor unerwünschten Außeneinflüssen zu schützen. Zum Schutz hochwertiger und empfindlicher Mikroelektronik werden ebenfalls hermetische Gehäuse eingesetzt. Diese Gehäuse stellen die Verbindung interner Komponenten zur Außenumgebung mittels beispielsweise eingeglaster Durchführungen her. Die Bauteile werden dabei gegen jegliche Art von äußeren Einflüssen, wie Strahlung, Funken, Gas und Luft sowie flüssige Medien sicher schützt.

Hermetisch und elektromagnetisch dichte Gehäuse zum Schutz von sensibler Elektronik werden vor allem in der Flugzeug- und Raumfahrtelektronik sowie in der Wehrtechnik verwendet. Es ist bekannt, Hybrid-Schaltungen aus passiven und aktiven elektronischen Bauteilen in einem metallischen Gehäuse unterzubringen und dieses unter Füllung mit Schutzgas dicht zu verschließen.

Es sind verschiedene Dichtungskonzepte bekannt, wie z.B. die in der Veröffentlichung DE 10 2005 040 844 A1 offenbarte wasserbeständige Gehäusestruktur. Diese Gehäusestruktur ist zwar lediglich gegen Fluide abgedichtet, nicht jedoch gegen Gase, was insbesondere bei Luft- und Raumfahrtanwendungen wegen den extremen Umwelteinflüssen von besonderer Wichtigkeit ist.

Weiterhin sind dichtende Gehäuseanordnungen aus den Druckschriften JP 2000-277203 A, DE 10 2006 037 355 B3, GB 2 135 533 A und US 2008/045072 A1 bekannt.

Eine Elektronikbox eines Flugzeuges kann ein sehr großes Fassungsvermögen aufweisen. Durch die Vielzahl an Steckern und Deckeln summiert sich dann eine große Dichtfläche auf. Durch die in der Luft entstehenden Druckdifferenzen zwischen Innen- und Außendruck von mehreren bar, muss das Dichtungskonzept sehr hohen und untypischen Anforderungen gerecht werden.

Bei den bisher bekannten hermetischen Gehäuseanordnungen, die insbesondere in der Luft- und Raumfahrttechnik verwendet wurden, gab es in der Vergangenheit immer wieder Probleme nicht nur in Bezug auf Bonding und Dichtigkeit, sondern auch Probleme hinsichtlich der Korrosion. Als Dichtungsmaterial für diese bekannten Gehäusestrukturen wurden bisher elastisch verformbare Kunststoffe, wie beispielsweise Fluorsilikon-Kautschuk (FVMQ), verwendet. Fluorsilikon kombiniert bekannterweise die guten Hoch- und Tieftemperatureigenschaften von Silikon mit guter Kraftstoff- und Ölbeständigkeit. Fluorsilikon O-Ringe als Dichtungen werden aber vor allem in Kraftstoffsystemen bei Temperaturen bis hin zu 177° C sowie in Anwendungen, bei denen die Beständigkeit von Silikon gegenüber trockener Wärme gefordert wird, eingesetzt. Aufgrund der relativ geringen Reißfestigkeit, der hohen Reibung und den ungenügenden Verschleißeigenschaften dieses Materials wird Fluorsilikon in der Regel nur für statische Anwendungen empfohlen.

Die US 4,960,391 beschreibt eine klassische Dichtungslösung von hermetischen Steckverbindern, bei welchen eine O-Ring-Dichtung, die in der Regel aus Elastomer angefertigt ist, in einer Nut eingefasst werden muss. Bei dieser Lösung ist es von Nachteil, dass sich an den Steckern und am Gehäuse Spalt- und Kontaktkorrosion bildet. Am Gehäusedeckel besteht das Risiko der Spaltkorrosion. Es ist in dieser Druckschrift vorgeschlagen worden, eine Paste zu verwenden, die als Korrosionsschutz dienen soll, jedoch keinen vollständigen Schutz gewährleistet. Ein weiterer Nachteil solcher Lösungen besteht darin, dass der O-Ring wegen der Verpressung sehr empfindlich ist. Eine zu hohe Verpressung der O-Ring-Dichtung führt zu einer Beschädigung und dadurch zum Ausfall der Dichtung. Eine zu geringe Verpressung dagegen hat zur Folge, dass die gewünschte Dichtigkeit nicht erreicht werden kann.

Eine Alternative zu den bekannten O-Ring-Dichtungen sind die statischen Dichtelemente wie Metall C-Ringe, die aber für die Anwendung in Leichtbaugehäusen, welche in der Regel aus Aluminium angefertigt werden, nur bedingt geeignet und sehr empfindlich sind. Des Weiteren lässt sich diese Dichtung nicht für komplexere Formen herstellen.

Was die Korrosionsbeständigkeit des Gehäuses betrifft, ist es bereits bekannt, dieses mit einer Antikorrosionsbeschichtung zu versehen. Der Oberflächenschutz des Metallgehäuses muss aber lokal gut leitfähig sein, um bestehende Anforderungen, wie Lightning, Bonding sowie Elektro-Mechanische-Verträglichkeit (EMV) erfüllen zu können. Die bisher bekannten leitfähigen Oberflächenbeschichtungen bieten nur einen mäßigen Korrosionsschutz. Fertigungstechnisch ist es aber nicht praktikabel, die Oberfläche bis zur Runddichtung mit einem nichtleitenden, hohen Korrosionsschutz zu versehen und nach der Anbringung der Dichtung, einen leitenden Oberflächenschutz aufzutragen.

Alternativ zu den bisher bekannten Dichtungen, wie Metall-Dichtungen und FVMQ, sind keine Dichtungstechnologien bekannt, welche den hohen Anforderungen an solchen Gehäusen, nämlich gasdicht mit einer sehr geringen Wasserdampfpermeation, Vibrationsbeständigkeit, Medienbeständigkeit, Langzeitstabilität, genügen. Solche Gehäuse, die in der Luft- und Raumfahrttechnik verwendet werden, müssen dazu sehr temperaturbeständig sein.

Aufgabe der vorliegenden Erfindung ist es daher, eine Gehäusestruktur anzubieten, die insbesondere in der Luft- und Raumfahrttechnik verwendet werden kann, welche einerseits hermetisch abgedichtet ist und andererseits die Entstehung von Korrosion signifikant reduziert, die Dichtigkeit und Wasserdampfpermeation verbessert und das EMV- sowie Bondingverhalten nicht negativ beeinflusst werden.

Diese Aufgabe wird erfindungsgemäß durch eine Gehäuseanordnung mit den Merkmalen des Anspruchs 1 gelöst.

Die erfindungsgemäße Gehäuseanordnung, die wenigstens ein Gehäuse zur Anbindung eines Steckverbinders aufweist, ist mit mindestens einer Dichtung versehen, die in einer im Gehäuse vorgesehenen aus einer Ausfräsung bestehenden Öffnung eingelegt wird. Bei der erfindungsgemäßen Lösung wird somit keine Nut mehr notwendig sein, in der die Dichtung eingelegt wird, sondern lediglich eine Ausfräsung im Steckerflansch oder im Gehäuse benötigt, in welcher die Dichtung genau angebracht wird. Mit dieser Anordnung kann die Dichtigkeit und das Handling (die Produktionskosten) merklich verbessert und zusätzlich die Korrosionsbildung deutlich vermindert werden, da hier eine mehr oder weniger punktuelle Abdichtung stattfindet und nicht entlang der ganzen Verbindungsfläche zwischen Gehäuse und Stecker, wie bei den oben genannten aus dem Stand der Technik bekannten Lösungen. Die Ausfräsung ermöglicht ein definiertes Verpressen der Dichtung und eine gute Handhabung bei der Montage der Dichtung.

Erfindungsgemäß ist die Dichtung eine kompressible Dichtung, die einen elastischen Anteil aufweist. Mit dieser Dichtung kann die Dichtigkeit im Vergleich zu den bisher bekannten Dichtungen aus Fluorsilikon-Kautschuk wesentlich verbessert werden, wobei zusätzlich die Korrosionsbildung deutlich vermindert werden kann. Die erfindungsgemäße kompressible Dichtung schützt den Aufbau vor eindringenden Medien und macht somit einen zusätzlichen Korrosionsschutz überflüssig

Vorzugsweise weist das Gehäuse einen Deckel auf, wobei die wenigstens eine Öffnung, die als Ausfräsung ausgebildet ist, an der Anbindung des Deckels an das Gehäuse vorgesehen ist. Die Ausfräsung kann sowohl am oberen, dem Deckel angrenzenden Bereich des Gehäuses als auch am unteren, dem Gehäuse angrenzenden Bereich des Deckels ausgeformt sein. Somit kann das Gehäuse nicht nur im Bereich der Steckverbindung, sondern auch am Deckel gasdicht abgedichtet werden. Durch den erfindungsgemäßen Aufbau wird der Bereich der Steckeranbindung an das Gehäuse und der Anbindung des Deckels an dem Gehäuse besser gegen Korrosion geschützt, wobei die elektromagnetische Verträglichkeit und das Bonding verbessert werden können.
Die Dichtung kann eine beliebig komplexe Geometrie aufweisen und lokal höher verpresst werden, so dass eine hohe Dichtigkeit gewährleistet ist.
Die Erfindung sieht vor, dass eine Oberflächenbeschichtung vor der Montage der Dichtung in Form eines nichtleitenden und beständigen Korrosionsschutzes aufgetragen wird. Diese wird umweltseitig bis zu den Bereichen, auf welchen die Dichtung aufliegt, am Gehäuse bzw. am Stecker aufgetragen.
Die Bondinganbindung zwischen Steckverbinder und Gehäuse wird mit einer leitenden Oberflächenbeschichtung, z. B. einer Chromatisierung realisiert.

Vorzugsweise werden die jeweiligen Beschichtungen in der im Gehäuse und im Deckel des Gehäuses vorgesehenen wenigstens einen Aussparung, angebracht.

Die vorliegende Erfindung wird nun anhand eines Ausführungsbeispiels und der Zeichnung näher erläutert. Es zeigen:
- Figur 1:: eine teilweise Schnittdarstellung einer erfindungsgemäßen Gehäuseanordnung im Bereich der Anbindung eines Steckers an einem Gehäuse gemäß einem Ausführungsbeispiel und
- Figur 2:: eine teilweise Schnittdarstellung einer erfindungsgemäßen Gehäuseanordnung im Bereich eines Gehäusedeckels mit einer Befestigungsschraube und mit dem erfindungsgemäßen Dichtungsaufbau.

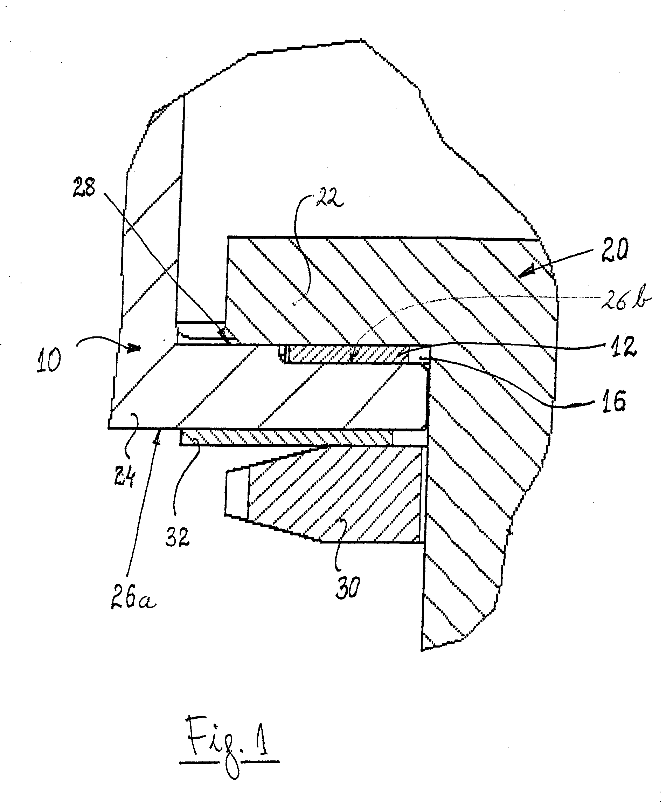

Figur 1 zeigt eine Schnittansicht einer erfindungsgemäßen Gehäuseanordnung mit einem Gehäuse 10 in Leichtbauweise mit einem erfindungsgemäßen Dichtungsaufbau an der Anbindung eines Steckverbinders 20 mit einer Dichtung 12. Die Dichtung 12 ist als eine kompressible Formdichtung ausgebildet, welche einen elastischen Anteil hat, und in einer Ausfräsung 16, die am Grenzbereich zwischen Gehäuse 10 und Steckerflansch 22 vorgesehen ist, angebracht. Die Dichtung 12 ist in die Ausfräsung 16 durch Verpressen eingebracht, wobei in der in Figur 1 gezeigten Ausführungsform der Steckverbinder 22 im verbundenen Zustand gezeigt ist. Der Stecker weist eine Schraubenmutter 30, zum Verschrauben des Steckverbinders 20 im Gehäuse 10, auf.
In diesem Ausführungsbeispiel ist zwischen der Schraubenmutter 30 des Steckverbinders 20 und einem angrenzenden Gehäuseflansch 24 eine Unterlegscheibe 32 zur besseren Anbindung des Steckers im Gehäuse 10 vorgesehen. Um einen erhöhten Korrosionsschutz zu gewährleisten, wird eine Oberflächenbeschichtung 26a, 26b, die einen elektrisch isolierenden Korrosionsschutz bietet, umweltseitig und somit auf der der Unterlegscheibe 32 angrenzenden Oberfläche 26a und in der Ausfräsung 16 der Dichtung 12 angrenzenden Oberfläche 26b des Gehäuseflansches 24 aufgetragen, wobei die Ausfräsung als eine Aussparung geformt ist. Diese Oberflächenbeschichtung 26 kann in Form eines nichtleitenden und beständigen Korrosionsschutzes, wie z. B. Schwefelsäure-Anodisierung, aufgetragen werden.

Auf die der Ausfräsung 16 des Gehäuses 10 angrenzende Fläche des Gehäuseflansches 24 wird ein elektrisch leitfähiger Korrosionsschutz angebracht. Somit wird die Bonding-Anbindung zwischen Steckverbinder 20 und Gehäuse 10 mit einer leitenden Oberflächenbeschichtung 28, wie z. B. Chromatierung, versehen.

Die Ausfräsung kann anstatt im Gehäuse 10, im angrenzenden Steckerflansch 22 vorgesehen sein. Die erfindungsgemäße kompressible Formdichtung kann dabei ebenfalls wie in der in Figur 1 gezeigten Ausführungsform durch Verpressen in die Ausfräsung eingelegt werden, wobei eine hohe Hermitizität gewährleistet wird.

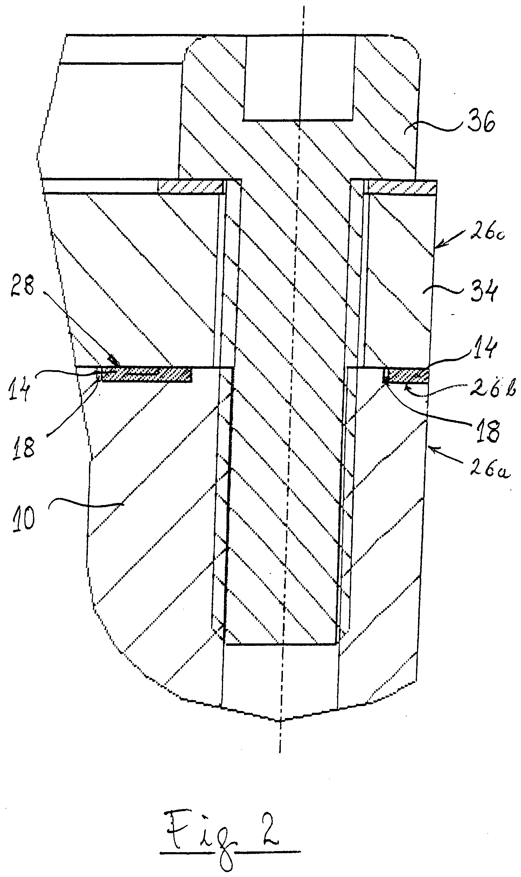

Figur 2 zeigt eine teilweise Schnittdarstellung einer erfindungsgemäßen Gehäuseanordnung im Bereich eines Gehäusedeckels 34, welcher mittels einer Schraube 36 am Gehäuse 10 befestigt wird. Bei dieser Ausführungsform ist eine Ausfräsung 18 vorgesehen, welche die Schraube 36 umfasst und am äußeren Rand des Gehäuses 10, welcher an Gehäusedeckel 34 grenzt, vorgesehen ist.

Wie aus Figur 2 ersichtlich, umschließt die Dichtung 14 in dieser Ausführungsform die Schraube 36, wobei an der Stelle zu bemerken ist, dass der Deckel 34 auch mit Hilfe von mehreren Schrauben an dem Gehäuse 10 befestigt werden kann. Es ist dabei vorteilhaft, dass die Dichtung 14 in einem Bereich nahe der Schraube 36 vorgesehen ist, um eine hohe Hermitizität zu gewährleisten. Die Ausfräsungen 18 sind in diesem Ausführungsbeispiel am oberen dem Deckel 34 des Gehäuses 10 angrenzenden Rand ausgebildet, wobei sie auch im Deckel 34 selbst vorgesehen werden können.

Es versteht sich, dass die erfindungsgemäße Dichtung 14, in einer oder aber auch in mehreren Ausfräsungen 18 im Bereich des Deckels 34 durch Verpressen eingelegt werden kann. Eine leitfähige Oberflächenbeschichtung 28 wird, wie in der in Figur 1 gezeigten Ausführungsform, an den gehäuseinnenliegenden, dichtungsangrenzenden Stellen am Gehäuse 10 und am Deckel 34 angebracht. Eine elektrisch isolierende Oberflächenbeschichtung 26a, 26b, 26c mit guten Korrosionsschutzeigenschaften ist in dieser Ausführungsform umweltseitig und somit auf der Gehäuseaußenseite 26a, der Deckelaußenseite 26c und in der Ausfräsung 18 (26b) vorgesehen.

Durch das erfindungsgemäße Dichtungsdesign für hermetische Gehäuse und Stecker, welche insbesondere in der Luft- und Raumfahrt eingesetzt werden kann, wird die Entstehung von Korrosion signifikant reduziert, die Dichtigkeit und Wasserdampfpermeation verbessert und das Elektro-Magnetische-Verhalten sowie das Bonding-Verhalten nicht mehr durch die extremen Außenbedingungen negativ beeinflusst.

Durch das erfindungsgemäße Konzept wird die ganze Gehäuseanordnung gasdicht, d.h. hermetisch, abgedichtet und zwar sowohl an den Steckern als auch am Deckel, soweit vorhanden. Durch die Auftragung einer Oberflächenbeschichtung an den dichtungsangrenzenden Stellen am Gehäuse bzw. am Deckel, erübrigt sich ein zusätzlicher Korrosionsschutz.

## Patentansprüche

1. Gehäuseanordnung mit wenigstens einem Gehäuse (10) und einem Steckverbinder (20), wobei die Gehäuseanordnung wenigstens eine Dichtung (12) aufweist, die in einer im Gehäuse (10) vorgesehenen Ausfräsung (16, 18) eingelegt ist, und wobei die Dichtung (12) aus einem kompressiblen Material mit elastischem Anteil besteht,
**dadurch gekennzeichnet,**
**dass** eine Bonding-Anbindung zwischen Steckverbinder (20) und Gehäuse (10) mit einer elektrisch leitenden Oberflächenbeschichtung (28) realisiert ist, die auf eine der Ausfräsung (16) angrenzende Fläche eines Gehäuseflansches (24) angebracht ist und einen Korrosionsschutz bietet;
**dass** eine elektrisch isolierende Oberflächenbeschichtung (26a, 26b) als beständiger Korrosionsschutz umweltseitig bis zu den Bereich auf welchen die Dichtung aufliegt und auf der an die Dichtung (12) angrenzenden Oberfläche des Gehäuseflansches (24) aufgetragen ist.

2. Gehäuseanordnung nach einem der vorhergehenden Ansprüche, **dadurch gekennzeichnet, dass** das Gehäuse (10) einen Deckel (34) aufweist, wobei wenigstens eine weitere Ausfräsung (18) an der Anbindung des Deckels (34) an das Gehäuse (10) vorgesehen ist.

3. Gehäuseanordnung nach Anspruch 2, **dadurch gekennzeichnet, dass** die jeweiligen Beschichtungen (26a,26b, 28) im Bereich der weiteren Ausfräsung (18) anbringbar sind.

4. Gehäuseanordnung nach einem der vorhergehenden Ansprüche, **dadurch gekennzeichnet, dass** die Dichtung (12) in die Ausfräsung (16) durch Verpressen einbringbar ist.

5. Gehäuseanordnung nach einem der vorhergehenden Ansprüche, **dadurch gekennzeichnet, dass** die Dichtung (12)
ringförmig oder beliebig komplex ausgebildet und lokal höher verpressbar ist.

6. Gehäuseanordnung nach Anspruch 1, **dadurch gekennzeichnet, dass** die Oberflächenbeschichtung (26a, 26b) eine gute Korrosionsbeständigkeit aufweist, die mittels Anodisierung auftragbar ist.

7. Gehäuseanordnung nach einem der vorhergehenden Ansprüche, **dadurch gekennzeichnet, dass** diese hermetisch abgedichtet ist.

## Claims

1. A housing arrangement, having at least one housing (10) and a plug-in connector (20), wherein the housing arrangement has at least one seal (12) that is placed in a milled portion (16, 18) provided in the housing (10) and wherein the seal (12) consists of a compressible material having an elastic portion,
**characterized in that**
a bonding connection between the plug-in connector (20) and the housing (10) is realized with an electrically conductive surface coating (28) that is applied to a surface of a housing flange (24) adjacent to the milled portion (16) and provides corrosion protection;
an electrically insulating surface coating (26a, 26b) as a resistant corrosion protection is applied at the environmental side up to the region on which the seal lies and at the surface of the housing flange (24) adjacent to the seal (12).

2. A housing arrangement in accordance with one of the preceding claims, **characterized in that** the housing (10) has a cover (34), wherein at least one further milled portion (18) is provided at the connection of the cover (34) to the housing (10).

3. A housing arrangement in accordance with claim 2, **characterized in that** the respective coatings (26a, 26b, 28) can be applied in the region of the further milled portion (18).

4. A housing arrangement in accordance with one of the preceding claims, **characterized in that** the seal (12) can be introduced into the milled portion (16) by pressing.

5. A housing arrangement in accordance with one of the preceding claims, **characterized in that** the seal (12) is configured as ring-shaped or in any desired complex manner and can be pressed locally more.

6. A housing arrangement in accordance with claim 1, **characterized in that** the surface coating (26a, 26b) has a good corrosion resistance which can be applied by means of anodization.

7. A housing arrangement in accordance with one of the preceding claims, **characterized in that** it is hermetically sealed.

## Revendications

1. Agencement de boîtier comprenant au moins un boîtier (10) et un connecteur enfichable (20), l'agencement de boîtier comportant au moins un joint d'étanchéité (12), qui est placé dans une fraisure (16, 18) prévue dans le boîtier (10), et le joint d'étanchéité (12) étant constitué d'un matériau compressible avec une part élastique,
**caractérisé**
**en ce qu'**un raccordement de type bonding entre le connecteur enfichable (20) et le boîtier (10) est réalisé au moyen d'un revêtement de surface (28) électriquement conducteur, qui est appliqué sur une surface adjacente à la fraisure (16) d'une bride de boîtier (24) et qui offre une protection contre la corrosion ;
**en ce qu'**un revêtement de surface (26a, 26b) électriquement isolant est appliqué comme protection durable contre la corrosion côté environnement jusqu'à la zone sur laquelle le joint d'étanchéité est posé et sur la surface adjacente au joint d'étanchéité (12) de la bride de boîtier (24).

2. Agencement de boîtier selon l'une des revendications précédentes, **caractérisé en ce que** le boîtier (10) comporte un couvercle (34), au moins une autre fraisure (18) étant prévue au niveau du raccordement du couvercle (34) au boîtier (10).

3. Agencement de boîtier selon la revendication 2, **caractérisé en ce que** les revêtements (26a, 26b, 28) respectifs peuvent être appliqués dans la zone de l'autre fraisure (18).

4. Agencement de boîtier selon l'une des revendications précédentes, **caractérisé en ce que** le joint d'étanchéité (12) peut être inséré dans la fraisure (16) par compression.

5. Agencement de boîtier selon l'une des revendications précédentes, **caractérisé en ce que** le joint d'étanchéité (12) se présente sous une forme annulaire ou aussi complexe que souhaitée et peut être comprimé localement plus fortement.

6. Agencement de boîtier selon la revendication 1, **caractérisé en ce que** le revêtement de surface (26a, 26b) présente une bonne résistance à la corrosion, qui peut être appliquée par anodisation.

7. Agencement de boîtier selon l'une des revendications précédentes, **caractérisé en ce que** celui-ci est étanche de manière hermétique.
